(19) Europäisches Patentamt
European Patent Office
Office européen des brevets

(11) Publication number: **0 406 959 A2**

# (12) EUROPEAN PATENT APPLICATION

(21) Application number: 90201748.2

(51) Int. Cl.5: C08G 73/12, C08G 59/40

(22) Date of filing: 29.06.90

(30) Priority: 29.06.89 US 373719

(43) Date of publication of application:
09.01.91 Bulletin 91/02

(84) Designated Contracting States:
DE FR GB IT

(71) Applicant: SHELL INTERNATIONALE RESEARCH MAATSCHAPPIJ B.V.
Carel van Bylandtlaan 30
NL-2596 HR Den Haag(NL)

(72) Inventor: Jackson, Roy Joseph
2323 Briar Lee Drive
Houston, Texas 77077(US)

(74) Representative: Aalbers, Onno et al
P.O. Box 302
NL-2501 CH The Hague(NL)

## (54) Maleimide composition.

(57) Novel trifunctional maleimides, a composition containing the trifunctional maleimides and a thermosettable resin such as an epoxy resin and prepregs and cured composites made therefrom. The trifunctional maleimides are reaction products of the reaction of maleic anhydride and bis(aminobenzyl)aniline followed by ring-closure to the trismaleimides.

EP 0 406 959 A2

# MALEIMIDE COMPOSITION

This invention relates to polyfunctional maleimide compositions. In one aspect, the invention relates to the preparation of maleimide/epoxy compositions having enhanced solubility in organic solvents.

Bismaleimides are high-performance thermosettable resins useful, because of their excellent thermal and electrical properties, in electrical and aerospace applications. In such applications, a bismaleimide in solution is impregnated into a fibrous substrate and partially cured to form a "prepreg". The prepreg is then placed in a mold or press, where it is heated to a temperature effective to drive off the solvent and to cure the resin to a hard formed object such as an electrical laminate for printed circuit board applications. A serious problem encountered in such applications, however, is the low solubility of conventional bismaleimides in low-boiling ketone, alcohol and glycol ether solvents which can be easily removed from the prepreg. Higher-boiling solvents are less desirable for prepregging because of environmental problems posed by certain high-boiling solvents and because they are more difficult to remove from the resin solution during the early stages of the prepregging process. Incomplete removal of the solvent during the early stages can result in the formation of voids in the prepreg and a diminution of the properties of the composite prepared from the prepreg.

One approach to this problem has been to react, or "advance", the bismaleimide with an aromatic amine, as in U.S. 3,625,912, or an aminophenyl-hydrazide, as in U.S. 4,211,861. Although such advanced bismaleimides have improved solubility, they can suffer from the problem of instability of the resin in the prepreg, resulting in difficulties in processing and inconsistent quality of the cured product.

It is therefore an object of the invention to provide a maleimide which has improved solubility in low-boiling solvents and properties suitable for electrical and composites applications. In a further aspect, it is an object of the invention to provide a maleimide which is stable in solution during the prepregging process.

According to the invention, a trifunctional maleimide is provided which is the product of reacting a bis-(aminobenzyl) aniline (BABA) with maleic anhydride to prepare a maleamic acid, and then heating the maleamic acid under ring-closing conditions to produce the trifunctional maleimide. The resulting trisimide of BABA has been found to be soluble in low-boiling solvents such as ketones, alcohols and glycol ethers and highly suitable for blending with thermosets such as epoxy resins for prepregging and composites applications.

The trifunctional maleimide can be prepared from a bis(aminobenzyl) aniline (BABA) composition which comprises, in major part, a compound of the formula

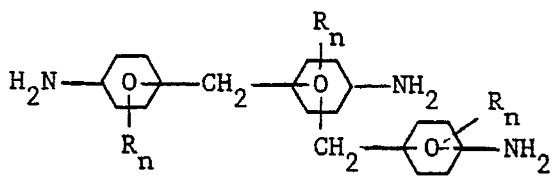

which each R is selected independently from $C_{1-3}$ alkyl or halide and n is 1-4. The BABA composition may contain a minor part of isomers and oligomers of other aromatic amines.

The BABA composition is reacted with maleic anhydride to prepare a maleamic acid intermediate. The reaction is generally carried out in a solvent such as dimethylformamide at a temperature within the range of 20 to 80 °C, preferably 10 to 40 °C. Reaction times can vary widely but will generally be within the range of 1 to 10 hours. The product maleamic acid is recovered by suitable means, for example by vacuum removal of the solvent and isolation of the product in water.

Ring-closure of maleamic acid of BABA can then be effected by heating in the presence of 3 to 20 moles, per mole of the maleamic acid, of acetic anhydride and from 1 to 2 moles of an alkali metal salt such as sodium acetate. The reaction is generally carried out at a temperature within the range of 50 to 120 °C, usually 70 to 100 °C, for a time of 1 to 10 hours. The resulting solution is filtered for removal of undissolved sodium acetate, and the acetic anhydride/acetic acid is removed by, for example, vacuum stripping. The crude imide is purified by, for example, dissolution in a solvent such as methyl ethyl ketone and reaction with a mild base for removal of acetic acid.

The product trisimide of BABA comprises a major portion of a trismaleimide according to the formula

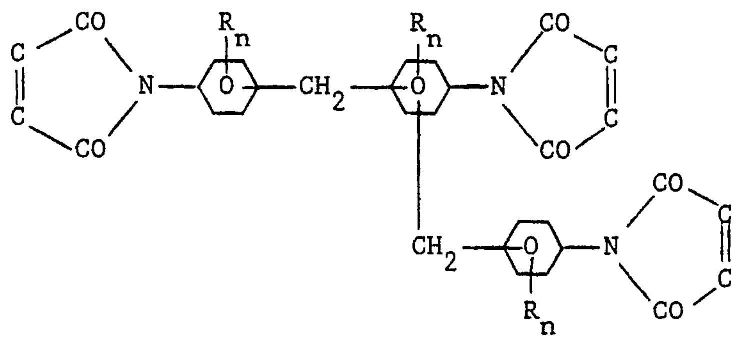

where each R is selected independently from $C_1$-$C_3$ or halide and n is an integer from 1-4, and a minor portion of isomers and oligomers of BABA and other aromatic amine imides such as difunctional and tetrafunctional imides. For use in prepregging applications, the BABA imide compositions will preferably comprise at least 85, most preferably at least 90, weight percent of the above trifunctional BABA imide and 15 percent or less of the minor constituents.

The invention also includes blends of the BABA imide composition with a second thermosettable resin, such as an epoxy resin, cyanate ester, bisbenzocyclobutene, propargyl ether, polyester and vinyl ester, for example. Epoxy resins are presently preferred because of the processing enhancement they provide to maleimides. The epoxy resin can be any curable epoxy resin having, on the average, 2 or more vicinal epoxide groups per molecule. It can be saturated or unsaturated, aliphatic, cycloaliphatic, aromatic or heterocyclic, and may bear substituents which do not materially interfere with the curing reaction. Such substituents, for flame-proof applications, can include bromine. The epoxy resin may be monomeric or polymeric, liquid or solid. Suitable epoxy resins include glycidyl ethers prepared by reacting epichlorohydrin with a compound containing at least one hydroxyl group carried out under alkaline reaction conditions. The epoxy resin products obtained when the hydroxyl group containing compound is bisphenol-A are represented below by structure I in which n is a number in the range of 0 to 10, usually 0 to 2. An example of such a preferred epoxy resin component is EPON Resin 1123-A-80 (EPON is a trade mark), a

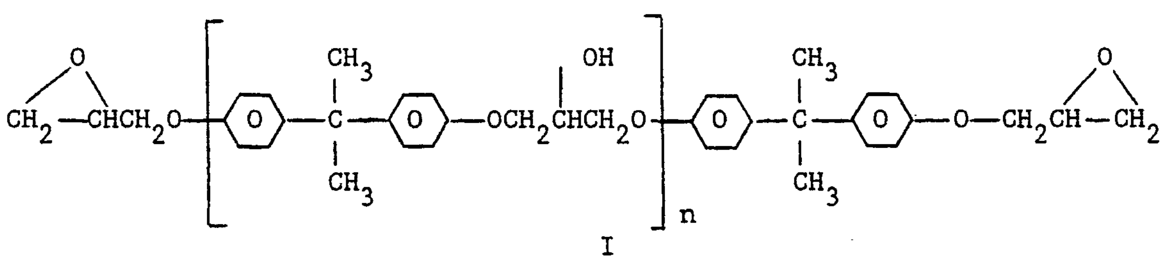

I

brominated diglycidyl ether of bisphenol-A having a molecular weight of 820. Also suitable as the epoxy resin component are multifunctional glycidyl ethers of tetraphenol ethane, as represented below in structure II. Such multifunctional epoxy resins are available commercially as EPON (EPON is a Trademark) 1031 from Shell Chemical Company.

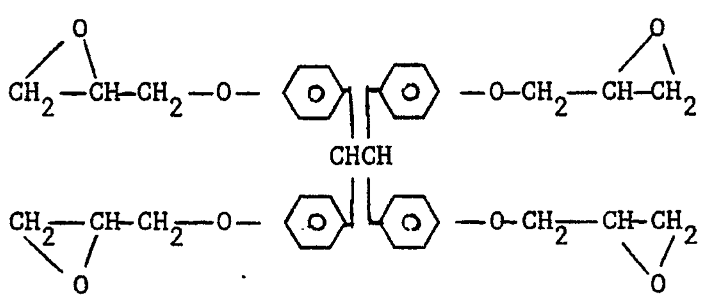

II

Another suitable class of epoxy resin components of a maleimide/epoxy composition are novolac-based epoxy resins (referred to herein as "novolac epoxy resins"), which are the glycidyl ethers of the product of reacting a phenol, such as phenol, resorcinol or bisphenol-A, with formaldehyde in acid solution. The preferred epoxy resins are solid bisphenol-A novolac epoxy resins having a molecular weight greater than 300, preferably greater than 500, weight per epoxide greater than 175, and an epoxide functionality greater than 1.75, preferably in the range of 2 to 5.

The thermosettable resin and the BABA imide will generally be used in combination in any relative amounts within the weight ratios from 10:90 to 90:10 which produce the desired physical and chemical properties for the intended application. The invention composition including the BABA imide resin, an epoxy resin and a curing agent is most suitable for making prepregs for electrical laminating and structural composites applications. For such applications, the BABA imide will generally be present in an amount greater than 25 weight percent, preferably 50 to 90 weight percent, most preferably 50 to 80 weight percent.

The trismaleimide can be cured thermally, with cure optionally accelerated by addition of a catalyst. Suitable catalysts include organic peroxides such as di-t-butyl peroxide, dicumylperoxide and t-butyl perbenzoate; organic bases such as imidazoles; aliphatic and aromatic amines such as methylene dianiline, m-phenylene diamine and bis(p-aminophenyl) sulfone; and inorganic bases such as sodium hydroxide, potassium hydroxide and sodium carbonate.

A trismaleimide/epoxy blend can include a curing agent for the epoxy resin. Suitable curing agents include imidazoles, aliphatic and aromatic amines, boron trifluorides, and the like as known in the art. The invention composition will preferably include a phenolic curing agent for the epoxy resin. The phenolic curing agent will preferably have a functionality greater than 1.75. The preferred curing agents are phenolic novolacs prepared by reacting a dihydroxy phenol such as resorcinol or bisphenol-A with formaldehyde in acid solution. The preferred phenolic novolac resin curing agents are bisphenol-novolacs having a weight per phenolic group of 60 to 500, preferably 60 to 300, and, on the average, more than 2 phenolic hydroxyl groups per molecule. Such phenolic novolacs are available under the tradename Epikure DX-175 from Shell International Chemical Company.

The curing agent for the epoxy resin will be present in the composition in an amount effective to cure the epoxy resin, which will generally be a stoichiometric amount of 0.75 to 1.25 equivalents per equivalent of epoxy resin. In terms of weight percent, the curing agent will be present in an amount generally from 10 to 70 weight percent, preferably 15 to 50, most preferably 20 to 40, based on the combined weight of epoxy resin and curing agent.

The curing agent, for flame-proof applications, can be a mixture of the phenolic resin curing agent and brominated phenolic curing agent such as brominated bisphenol-A. The brominated bisphenol-A will be present in an amount effective to increase flame retardancy, generally an amount up to 40 weight percent, usually 5 to 20 weight percent, based on the combined weight of epoxy resin and curing agent(s).

In order to promote faster and/or lower temperature cure of the resin components of the composition, an optional cure accelerator may be used. Many suitable accelerators, such as tertiary amines, imidazoles, phosphenes, octoates and boron trifluorides for example, are known in the art. Because of their availability and performance characteristics, imidazoles such as 2-methyl imidazole, 2-methyl-4-ethyl imidazole and isopropyl imidazole, are preferred. The accelerator will be present in the composition in an amount effective to increase the cure rate and/or lower the cure temperature of the compositions, generally in an amount from 0.01 to 5, preferably from 0.05 to 2 weight percent, based on the weight of the epoxy, BABA imide and curing agent components of the composition.

The invention composition can, for applications such as prepregging, include an organic solvent or diluent present in an amount effective to decrease the viscosity of the system for easier processing. For prepregging applications, for example, sufficient solubility of the maleimide will generally be 40-60%. Solvent systems comprising 90-100, preferably 100, weight percent, of polar organic solvents such as ketones, alcohols and glycol ethers having boiling points less than 135° C, preferably less than 125° C, are preferred for prepregging because they are more readily removed from the composition at relatively low temperatures and at a relatively early stage of the pre-curing process, minimizing blister formation in the prepreg. The preferred solvents are ketones such as acetone, methyl ethyl ketone and methyl isobutyl ketone, for example, and glycol ethers such as ethylene glycol monomethyl ether, ethylene glycol monoethyl ether, and propylene glycol monomethyl ether. Also suitable are low-boiling alcohols such as methanol, ethanol, isobutanol and propanol. Higher-boiling solvents such as dimethyl formamide and N-methyl pyrrolidone conventionally used in bismaleimide formulations are less desirable and will preferably be employed in amounts no greater than 10 weight percent, based on the weight of the solvent. Methyl ethyl ketone and blends thereof with glycol ethers are the preferred solvents for the BABA imide and the

imide/epoxy blend. The proportion of solid components in the composition will vary widely depending upon the amount of the other constituents present and the intended application of the composition, but for prepregging applications the solvent will generally constitute at least 15 weight percent of the total weight of the imide/epoxy solution. Preferably, the solvent will be present in the solution in an amount from 15 to 50, most preferably 30 to 45 weight percent. The resin components and optional accelerator can be stirred into the selected solvent at ambient temperature or with optional mild heating not greater than 40° C to form the "varnish", or prepregging formulation.

For preparation of reinforced laminates from the varnish, a substrate of glass, carbon, quartz, poly(p-phenylenebenzobisthiazole), boron, paper or like material, in chopped, mat or woven form, is impregnated with the resin in molten or varnish form. A prepreg is formed by heating the impregnated substrate at a temperature sufficient to remove the solvent and to partially cure without gelation, or "B-stage," the blended resin system, generally 120° C to 180° C, preferably 150° C to 175° C, for a time of up to 10 minutes, preferably 30 seconds to 2 minutes. A laminate is fabricated by subjecting a set of layered prepregs to conditions effective to cure the resins and to integrate the prepregs into a laminated structure. The laminate can optionally include one or more layers of conductive material such as copper. Laminating conditions generally include a time of 30 minutes to 4 hours, preferably 1 hour to 2 hours, a temperature of 160° C to 300° C preferably 180° C to 210° C and a pressure of 50 to 500 psi. The composition can also include optional constituents such as inorganic fillers and additional flame retardants, for example. The laminates can be optionally "post-cured" by heating at a temperature of 200 to 235° C at ambient pressure for 1 to 6 hours to improve thermal properties.

In addition to high-performance laminates, the invention composition is useful for electrical component encapsulation, molding powders, coatings, and structural composites parts fabrication.

## Example 1

### Preparation of Imide from Bis(aminobenzyl)aniline

Maleamic acid was prepared as follows. Into a four-neck flask equipped with a reflex condenser, addition funnel, thermocouple, nitrogen inlet tube, and stirrer were added 297.5 grams of bis(aminobenzyl) aniline (BABA) and 1000 ml of dimethyl formamide (DMF). The solution was cooled to 10° C, and 267.7 grams of maleic anhydride dissolved in 900 ml DMF were added over 1.5 hours. The DMF was vacuum stripped to yield 527.9g maleamic acid (90% yield).

Into a four-neck flask equipped with a reflux condenser, dropping funnel, thermocouple, nitrogen inlet tube and stirrer were added 527.9g maleamic acid, 1205g acetic anhydride, and 86.6g sodium acetate. The mixture was heated to 100° C, at which the maleamic acid went into solution. Stirring was continued for four hours, after which the imide was filtered and the acetic acid/acetic anhydride was vacuum-distilled. The solid crude imide was taken up in methyl ethyl ketone and washed several times with pH 8 water until the wash water was neutral. The methyl ethyl ketone was removed under vacuum to yield approximately 60% of theoretical pure imide.

## Example 2

### Properties of BABA Imide

Properties of BABA imide as prepared in Example 1 were compared with properties of imide prepared from methylene dianiline. Varnishes were prepared for both resins. The BABA imide was dissolved in a solvent mixture of MEK and methyl oxitol, a desired low-boiling solvent for laminate applications, while the MDA imide was dissolved in DMF, a less desirable laminating solvent necessary for sufficient dissolution of the MDA imide. 2-methyl imidazole was used as a cure accelerator in equivalent (stoichiometric) amounts. Properties of imide resins are shown in Table 1. Table 2 shows the properties of imide/epoxy blends containing EPON Resin System 1151, a formulated novolac epoxy resin, phenolic curing agent and tetrabromo bisphenol-A. As shown in Table 2, the glass transition temperature of the cured BABA imide/epoxy blend was significantly higher than that for MDA imide/epoxy, and the coefficient of thermal expansion was significantly lower for the BABA/epoxy blend, both desirable findings for electrical laminate

applications.

Table 1

| Comparison of MDA and BABA Imide Properties | | |
|---|---|---|
| Prepreg Properties: | MDA Varnish[a] | BABA Varnish[b] |
| Gel Time (171 °C, sec) | 98 | 118 |
| Prepreg Time (163 °C, sec) | 1.25 | 2 |
| Prepreg Dust Gel (171 °C, sec) | 79 | 106 |
| Press Cycle (180 °C, hr) | 4 | 1 |
| Post Cure (220 °C, hr) | 4 | 4 |
| Laminate Properties: | | |
| Resin Content | 33% | 32% |
| Tg[c] (°C) | 330 | 378 |
| 5% wt loss temp (TGA) | 385 | 408 |

[a]100g Compimide$^R$ 183 (MDA imide); 54g dimethyl formamide; 0.2g 2-methyl imidazole; 11.6g methyl oxitol
[b]100g BABA imide; 46.7g methyl ethyl ketone; 20g methyl oxitol; 1.44g 2-methyl imidazole.
[c]DMA damping peak max

Table 2

| Comparison of MDA Imide/Epoxy with BABA Imide/Epoxy Properties | | |
|---|---|---|
| Prepreg Properties: | MDA Varnish[a] | BABA Varnish[b] |
| Gel Time (163 °C, sec) | 167 | 163 |
| Prepreg Time (171 °C, min) | 3 | 2.5 |
| Prepreg Dust Gel | 94 | 76 |
| Post Cure (220 °C, hr) | 4 | 4 |
| Laminate Properties: | | |
| Tg[c] | 318[d] | 388 |
| 5% wt loss temp (TGA) | 360 | 411 |
| Coef of thermal expansion (50-250 °C, m/m C) | 80-90<br>90 | <50<br>36-40[e]<br>27-37[f] |

[a]100g Compimide$^R$ 183 (MDA imide); 66.6g dimethyl formamide; 42.8g EPON Resin System 1151; 0.086g 2-methyl imidazole
[b]100g BABA imide; 46.7g methyl ethyl ketone; 20 methyl oxitol; 41.6g EPON Resin System 1151; 0.36g 2-methyl imidazole
[c]DMA damping peak max
[d]The maximum in the damping peak. The epoxy phase shows a shoulder at 216 °C.
[e]First heating from 50-300 °C.
[f]Second heating from 50-300 °C.

Example 3

To illustrate the effect of a high-boiling solvent on the properties of an imide resin, BABA trisimide was dissolved in dimethylformamide (DMF) at 60% by weight. To the BABA trisimide solution was added EPON. Resin System 1151-B-60 to provide an overall ratio of BABA trisimide to epoxy resin system of 70/30. The gel time was adjusted with 2-methyl imidazole to give a gel time at 171°C of 137 sec (0.15 phr). The varnish was coated on glass mat and advanced to a "B" stage by heating at 163°C in a forced-air oven for 6 min. The resulting prepreg had a dust gel time of 69 sec. Eight sections of the prepreg were cured into a laminate by pressing for 1 hr at 180°C. Three such laminates were post-cured for 4 hours at 220°C, 250°C and 300°C, respectively. Properties of the laminates are shown below in Table 3.

Table 3

| Laminate Properties | | | |
|---|---|---|---|
| | 220°C | 250°C | 300°C |
| 5% wt loss temp. | 388°C | 387 | 425 |
| Coef of thermal expansion | 99 | 85 | <50 |
| Tg | 230°C | 251 | 449 |

As can be seen from a comparison of these results with those of Example 2 for a BABA imide/epoxy in a low-boiling solvent subjected to a 220°C post-cure, comparable properties were possible in DMF solvent only with a post-cure temperature of 300°C, an undesirably high post-cure for some applications.

Example 4

To illustrate the instability of MDA imide in methyl ethyl ketone and to determine the stability of BABA trisimide contaminated with MDA imide, an experiment was performed in which four 60% solutions in methyl ethyl ketone containing BABA imide/MDA imide weight ratios of 100/0, 83/17, 77/23 and 74/26, respectively, were heated to 50°C and held for 30 minutes. The solutions were then allowed to cool to room temperature and were observed for development of crystals. Times to appearance of crystals for each solution are shown in Table 4.

Table 4

| | | | | |
|---|---|---|---|---|
| BABA/MDA imide ratio | 100/0 | 83/17 | 77/23 | 74/26 |
| Time to crystallization (days) | 31+ | 21 | 1 | 1 |

**Claims**

1. A composition comprising a) at least 85 weight percent, based on the weight of maleimide components of the composition, of a trifunctional maleimide of the formula

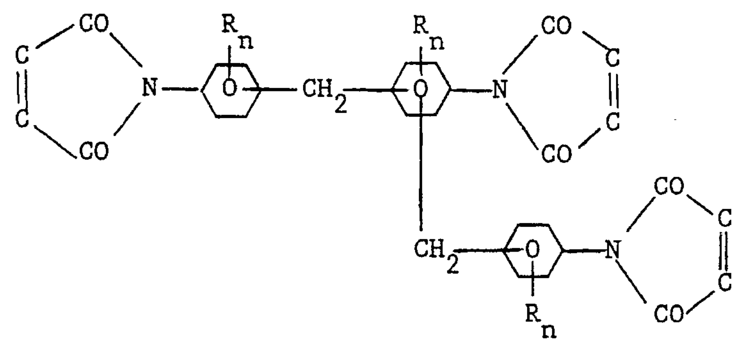

in which each R is selected independently from $C_{1-3}$ alkyl and halide and n is 1-4, and b) no more than 15 weight percent mono, di and tetrafunctional maleimides.

2. The composition of claim 1 which further comprises an organic solvent having a boiling point less than 135° C.

3. The composition of claim 1 which further comprises an aromatic amine.

4. A composition comprising: (a) a thermosettable resin; (b) from 10 to 90 weight percent, based on the weight of (a) and (b), of a trifunctional imide which can be represented by the chemical structure

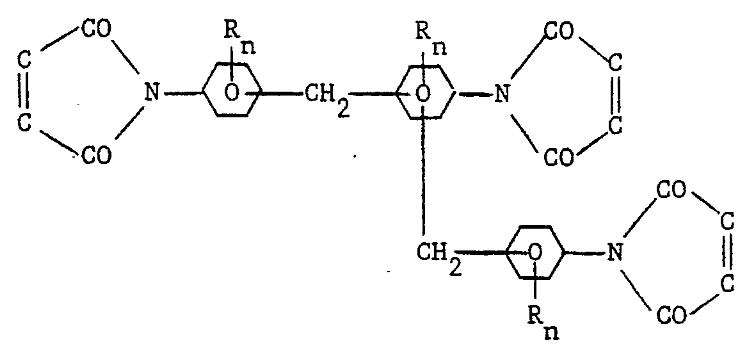

in which each R is selected independently from $C_{1-4}$ alkyl and halide and n is 1-4.

5. The composition of claim 4 in which the thermosettable resin is an epoxy resin and the composition further comprises a curing agent and a cure accelerator.

6. The composition of claim 4 or 5 which further comprises an organic solvent having a boiling point less than 135° C.

7. An article of manufacture comprising the cured composition of claim 1 or 4 and a fibrous substrate.

8. A prepreg comprising the composition of claim 1 or 4 and a fibrous substrate.